# FASCICULE DE BREVET EUROPEEN

(11) **EP 4 083 706 B1**
(45) Date de publication et mention de la délivrance du brevet: **19.02.2025**
(21) Numéro de dépôt: 22170196.4
(22) Date de dépôt: 27.04.2022
(51) Int. Cl.: G03F 7/00, G03F 7/027, G03F 7/075

(54) **PROCEDE DE STRUCTURATION DE SURFACE HYBRIDE PAR GRAVURE PLASMA**
VERFAHREN ZUR STRUKTURIERUNG EINER HYBRIDEN OBERFLÄCHE DURCH PLASMAÄTZEN
METHOD FOR STRUCTURING A HYBRID SURFACE BY PLASMA ETCHING

(30) Priorité: 30.04.2021 FR 2104582
(43) Date de publication de la demande: 02.11.2022
(73) Titulaire: Commissariat à l'Energie Atomique et aux Energies Alternatives, 75015 Paris (FR)
(72) Inventeur: TEYSSEDRE, Hubert, 38054 GRENOBLE CEDEX 09 (FR); POSSEME, Nicolas, 38054 GRENOBLE CEDEX 09 (FR); MEHREZ, Zouhir, 38024 GRENOBLE (FR); MAY, Michael, 38024 GRENOBLE (FR)
(74) Mandataire: Brevalex

(56) Documents cités:
- WO-A1-2013/171420
- US-A1- 2011 006 674
- NIKOLAOS VOURDAS ET AL: "Nanotextured super-hydrophobic transparent poly(methyl methacrylate) surfaces using high-density plasma processing", NANOTECHNOLOGY, INSTITUTE OF PHYSICS PUBLISHING, BRISTOL, GB, vol. 18, no. 12, 28 March 2007 (2007-03-28), pages 125304, XP020118931, ISSN: 0957-4484, DOI: 10.1088/0957-4484/18/12/125304
- TSEREPI ANGELIKI ET AL: "Tailoring the surface topography and wetting properties of oxygen-plasma treated polydimethylsiloxane", JOURNAL OF APPLIED PHYSICS, AMERICAN INSTITUTE OF PHYSICS, 2 HUNTINGTON QUADRANGLE, MELVILLE, NY 11747, vol. 98, no. 11, 2 December 2005 (2005-12-02), pages 113502 - 113502, XP012077895, ISSN: 0021-8979, DOI: 10.1063/1.2136421
- ORUGANTI NAGARAJU ET AL: "Process variability in surface roughening of SU-8 by oxygen plasma", vol. 19, no. 7, 1 July 2013 (2013-07-01), DE, pages 971 - 978, XP055871121, ISSN: 0946-7076, Retrieved from the Internet <URL:https://link.springer.com/content/pdf/10.1007/s00542-012-1680-0.pdf> [retrieved on 20211109], DOI: 10.1007/s00542-012-1680-0
- VAN PELT STIJN ET AL: "Local wettability tuning with laser ablation redeposits on PDMS", APPLIED SURFACE SCIENCE, ELSEVIER, AMSTERDAM, NL, vol. 303, 12 March 2014 (2014-03-12), pages 456 - 464, XP028844206, ISSN: 0169-4332, DOI: 10.1016/J.APSUSC.2014.03.025
- BERWIND M F ET AL: "Rapidly prototyping biocompatible surfaces withdesigned wetting properties viaphotolithography andplasma polymerization", MICROFLUID NANOFLUID, 17 August 2017 (2017-08-17), pages 144, XP055871134, Retrieved from the Internet <URL:https://link.springer.com/content/pdf/10.1007/s10404-017-1984-6.pdf> [retrieved on 20211209]
- ZHAO XIAOXIAO ET AL: "Flexible-templated imprinting for fluorine-free, omniphobic plastics with re-entrant structures", JOURNAL OF COLLOID AND INTERFACE SCIENCE, ACADEMIC PRESS,INC, US, vol. 585, 20 October 2020 (2020-10-20), pages 668 - 675, XP086421246, ISSN: 0021-9797, [retrieved on 20201020], DOI: 10.1016/J.JCIS.2020.10.046

## Description

### DOMAINE TECHNIQUE ET ART ANTERIEUR

L'invention concerne les techniques de structuration, permettant de réaliser une structure hybride, comportant par exemple des motifs à l'échelle micrométrique et une gravure d'au moins une partie de ces motifs afin de leur conférer une rugosité à l'échelle nanométrique.

Ce type de structure hybride permet notamment de créer une surface qui a des propriétés antibactériennes et anti-virales), avec une texturation rugueuse contrôlée sur au moins une partie de la surface des motifs.

Les surfaces anti-bactériennes sont généralement créées soit par des dépôts par plasma avec des précurseurs riches en Si (par plasma « HMDSO ») (voir l'article de Zouaghi et al. 2018, Applied Surface Science, Volume 455, 15 October 2018, Pages 392-402 : « Atmospheric pressure plasma spraying of silane-based coatings targeting whey protein fouling and bacterial adhesion management »), soit par ablation laser d'une surface métallique (S.Moradi et al.; ACS Appl. Mater. Interfaces 2016, 8, 27, 17631-17641, June 20, 2016, https://doi.org/10.1021/acsami.6b03644: « Effect of Extreme Wettability on Platelet Adhesion on Metallic Implants: From Superhydrophilicity to Superhydrophobicity »), soit par électrolyse pour réaliser de l'oxyde poreux (Thukkaram et al., ACS Appl. Mater. Interfaces, 2020 : « Fabrication of microporous coatings on titanium implants with improved mechanical, antibacterial and cell-interactive properties »). On connaît également l'article de Dionysia Kefallinou et al. « Optimization of Antibacterial Properties of "Hybrid" Metal-Sputtered Superhydrophobic Surfaces », Coatings 2020, 10, 25, 30 Déc 2019.

Aucune de ces techniques connues ne permet de créer de manière simple sur un substrat une surface qui présente à la fois des motifs micrométriques et une structure plus fine, à l'échelle nano métrique. Un procédé de formation de motifs micrométriques sur une surface de substrat est en soi connu de WO2013/171420 A1.

### EXPOSE DE L'INVENTION

L'invention concerne d'abord un procédé de réalisation d'une structure hybride, comportant les étapes définies en revendication 1

La polymérisation de la résine peut avoir lieu entre les étapes de formation d'une structure comportant une pluralité de motifs et de formation d'une rugosité sur au moins une partie de la surface des motifs, telles que définies en revendication 1.

Chaque motif a au moins une dimension, mesurée parallèlement ou perpendiculairement au substrat, comprise entre 50 nm et 500 µm, par exemple 100 nm ou 1 µm. Ainsi les motifs peuvent être dits « micrométriques ».

Les motifs peuvent être réalisés dans la couche de résine minérale par exemple par un procédé de lithographie optique, électronique ou encore par une technique de nano impression.

Les motifs, par exemple micrométriques, peuvent avoir soit une forme de créneau, soit une forme de cône ou de pyramide ou autre. Ces motifs permettent d'obtenir une surface démouillante sur laquelle les bactéries n'adhèrent pas, ce qui peut être encore renforcé par un greffage.

Lors d'une application à des bactéries, la dénaturation de celles-ci peut résulter de la rugosité (nanostructure) mais peut également être obtenue/renforcée par les motifs ayant une ou des forme(s) saillante(s) (cône ou pyramides par exemple).

La rugosité (correspondant à une structuration nanométrique avec une dimension critique par exemple inférieure à 50 nm) peut être obtenue par exemple par un procédé oxydant, du type comportant au moins une espèce ou un gaz permettant de plus ou moins consommer la phase minérale de la résine, et ainsi de révéler des zones ayant des lacunes en atomes ou molécules de Si et/ou SiO₂. Ces atomes ou molécules Si et/ou SiO₂ ne sont pas consommés par ce procédé oxydant (les atomes de Si pouvant être néanmoins oxydés en SiO₂). Ce procédé oxydant est par exemple une gravure par plasma, isotrope ou anisotrope.

Selon l'invention, on utilise donc 2 étapes ou niveaux de structuration :
- au cours de l'étape b), un procédé de lithographie ou de nano impression appliqué à la résine minérale (contenant de préférence une proportion maîtrisée de Si et/ou de SiO₂, comprise entre 1 et 30 % en masse molaire) pour avoir des motifs, de préférence à l'échelle micrométrique, dont la forme, la période et les dimensions sont définies par les paramètres de ce procédé;
- au cours de l'étape c), une rugosité aléatoire est générée en surface desdits motifs, en retirant des parties carbonées, par exemple grâce à un procédé oxydant, par exemple encore un plasma oxydant, lequel peut être isotrope ou anisotrope.

La surface ainsi créée est riche en Si et/ou en SiO₂, ce qui permet, en plus de la texture de surface ainsi obtenue, laquelle est favorable aux applications antibactériennes et antivirales, d'y greffer des silanes, par exemple pour changer les propriétés d'énergie de surface en vue d'augmenter l'effet démouillant. Les silanes viennent donc aider au démouillage, et complètent donc avantageusement les motifs ou microstructures.

Dans un procédé selon l'invention :
- le substrat peut être par exemple en silicium ou en une résine négative réticulée ou en verre;
- et/ou la rugosité peut être sur la partie haute et la partie basse des motifs et éventuellement sur des parois latérales qui relient ces parties haute et basse ;
- et/ou la rugosité peut avoir une valeur moyenne comprise entre 0,5 nm et 30 nm ;
- et/ou des motifs voisins peuvent être séparés par une distance comprise entre 50 nm et 1µm ou même 500 µm;
- et/ou le fond (ou partie basse) des motifs peut constituer de la résine dans laquelle les motifs sont réalisés, ou peut-être la surface dudit substrat ;
- et/ou au moins un agent fluoré ou du silane peut être greffé sur au moins une partie de la surface.

### BRÈVE DESCRIPTION DES DESSINS

- Les figures 1A et 1B représentent des exemples de nano impression dans une résine minérale à 4 % de Si et/ou SiO₂,
- Les figures 2A et 2B représentent un exemple de résine minérale post impression, avec illustration de la présence des éléments Si et/ou SiO₂; avant (figure 2A) et après (figure 2B) mise en oeuvre du procédé oxydant ;
- Les figures 3-5 représentent des images SEM (FOV = 3 µm) de surfaces obtenues par un procédé de gravure sans bias, avec différents plasma, sans (figure 3) ou avec (figures 4, 5) espèces fluorées, l'exemple de la figure 3 n'étant donc pas conforme à l'invention;
- la figure 6 représente l'évolution de la rugosité Ra (en nm) de la surface d'une résine traitée selon l'invention pour une durée de procédé de 200 secondes et des ratios SF₆/O₂ compris entre 0 et 3:25 ;
- les figures 7-8 représentent des exemples de traitement selon l'invention, appliqués à des surfaces ayant une proportion de Si et/ou SiO₂ trop importante pour l'obtention d'une structure hybride;
- les figures 9-10 représentent des exemples de traitement selon l'invention, appliqués à des surfaces ayant une proportion adéquate de Si et/ou SiO₂ pour l'obtention d'une structure hybride;
- les figures 11-12 représentent des variantes de procédés selon l'invention.

### EXPOSÉ DÉTAILLÉ DE MODES DE RÉALISATION PARTICULIERS

Dans le cadre de la présente invention, on choisit une résine minérale contenant une proportion de Si et/ou SiO₂ (noté Si/SiO₂ dans la suite) comprise entre 1 % et 30 % (en masse molaire). Comme expliqué plus loin, une résine comportant une proportion plus importante de Si/SiO₂ peut être traitée pour réduire celle-ci en ajoutant un composé organique, tel qu'une autre résine ou un précurseur. Par ailleurs, si une résine comporte une proportion insuffisante de Si/SiO₂, une implantation de Si est possible pour accroître celle-ci.

La résine choisie, en particulier sa proportion de Si/SiO₂ comprise entre 1 % et 30 %, est compatible avec au moins un procédé de lithographie optique, électronique ou une technique alternative (comme la nano-impression) pour réaliser un premier niveau de structures. Pour chaque résine, on peut effectuer un processus de qualification par rapport à chaque technique comme par exemple décrit dans l'article de Kretz et al. « Comparative study of calixarene and HSQ resist systems for the fabrication of sub-20 nm MOSFET device demontrators », paru dans Microelectronic Engineering, 78-79, 2005, 479-483. Comme expliqué plus loin, les techniques de lithographie optique ou électronique ne permettent pas de conserver de la résine au fond des motifs, ce qui est par contre possible avec la technique de nano-impression (dans ce cas, la profondeur h des motifs est inférieure à l'épaisseur de la couche de résine). La nanoimpression peut permettre également de réaliser facilement des formes saillantes (Cône ou pyramide notamment) qui vont permettre de dénaturer les bactéries.

Selon la forme des motifs souhaités et leurs dimensions, et en fonction des propriétés de la résine et de la technique choisie pour former les motifs, on définit la quantité de résine à mettre en oeuvre ainsi que les paramètres d'étalement, d'exposition, de développement et les paramètres des éventuels recuits intermédiaires.

L'exemple présenté ci-dessous met en oeuvre des résines de nano-impression, commerciales ou non. Ainsi on peut prendre la résine EVG UVA (version 1 à 4). Cette résine comprend principalement deux molécules, en respectivement 3.6 et 0.03 % en masse dans le matériau :
- Propyl Acrylate Si(OH)₃;
- Phenyl bis(2,4,6-trimethylbenzoyl)phosphine oxide .

La résine permet de reproduire des motifs :
- ayant une largeur et/ou profondeur comprise entre 50 nm et plusieurs centaines de micromètres, par exemple comprise entre 50 nm et 500 µm ;
- pour une période (distance séparant deux motifs voisins) qui peut être compris entre 50 nm ou 100 nm et plusieurs centaines de micromètres, par exemple comprise entre 50 nm ou 100 nm et 500 µm ou même 1 mm.

La résine de cet exemple contient 4% de silicium, qui est dans la gamme adéquate 1%-30% pour mettre en oeuvre un procédé selon l'invention.

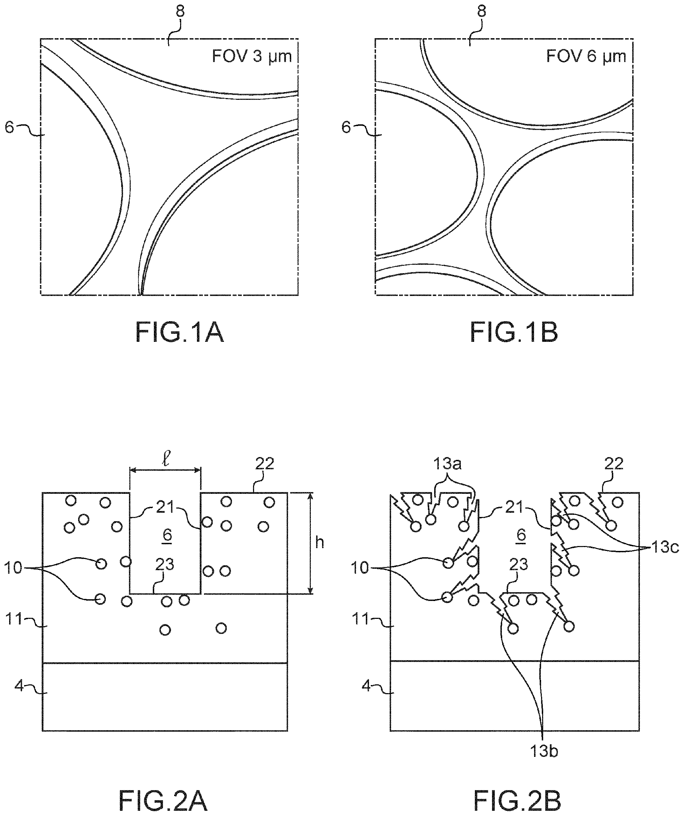

La mise en forme par nano-impression de cette résine se fait ici grâce à un moule, par exemple un moule souple en PDMS, par exemple encore à base d'acrylate (ou en un autre matériau compatible avec cette résine) transparent à la longueur d'onde de 365 nm (longueur d'onde de photopolymérisation, laquelle a lieu après nano-impression). Ce peut être un moule de référence EVG AS2, avec lequel on peut reproduire des cavités 6, 2 cavités voisines étant séparées par une distance de 500 nm, chaque cavité ayant une hauteur h (voir figure 2A) de marche de 500 nm. Ces dimensions sont données à titre d'exemple : plus généralement, chaque motif a au moins l'une de ses dimensions mesurées parallèlement (l) ou perpendiculairement (h) au substrat, comprise entre 50 nm et 1 mm. l peut notamment être la largeur de l'ouverture de la cavité, mesurée entre les parois latérales 21 de celle-ci ; h peut être la profondeur de cette cavité, mesurée entre la surface supérieure 22 du motif et sa surface inférieure (ou son fond ou sa partie basse) 23.

Ces cavités 6 sont illustrées :
- en figures 1A et 1B, qui sont des images par microscopie électronique à balayage (SEM), avec un champ de vision (FOV) respectivement de 3 µm (figure 1A) et 6 µm (figure 1B) ;
- plus schématiquement en figure 2A, qui représente un motif vu en coupe avec une répartition des espèces Si/SiO₂ (symbolisées par des points clairs) dans la résine 11 photopolymérisée.

Dans l'exemple illustré par ces figures, les paramètres utilisés pour le procédé de mise en forme de la résine sont les suivants (avec équipement de type « cluster EVG Hercules »): 500 mbar (pression correspondant à l'allègement de force que l'on met sur le moule souple), puissance de la lampe de 600 mW/cm² (cette puissance peut être réglée, par exemple entre 50 et 600 mW/cm²), pendant une durée d'exposition de 8s, pour une épaisseur initiale de résine de 800 nm.

Toute autre forme de motif peut être réalisée, par exemple des motifs en forme de cône ou de pyramide ou autre. Le procédé mis en oeuvre est alors adapté pour la forme souhaitée ; par exemple, la forme du moule est adaptée à la forme de motif souhaitée.

Afin de générer de la rugosité sur les motifs réalisés, un procédé oxydant est utilisé, comprenant au moins une espèce ou gaz permettant de consommer légèrement la phase minérale pour révéler les zones ayant des lacunes en composés Si/SiO₂. Par exemple, et de façon non limitante, ce gaz peut être composé d'un élément fluoré (CF₄, SF₆) et le ratio Oxygène/Fluor peut être modifié afin de faire varier la rugosité. La figure 2B représente le motif de la figure 2A, réalisé dans la résine minérale 11, après mise en oeuvre du procédé oxydant : les références 13a, 13b, 13c désignent les rugosités obtenues (il s'agit bien sûr de représentations schématiques), tant sur les parties supérieures 22 des motifs, que sur les flancs 21 ou sur le fond 23.

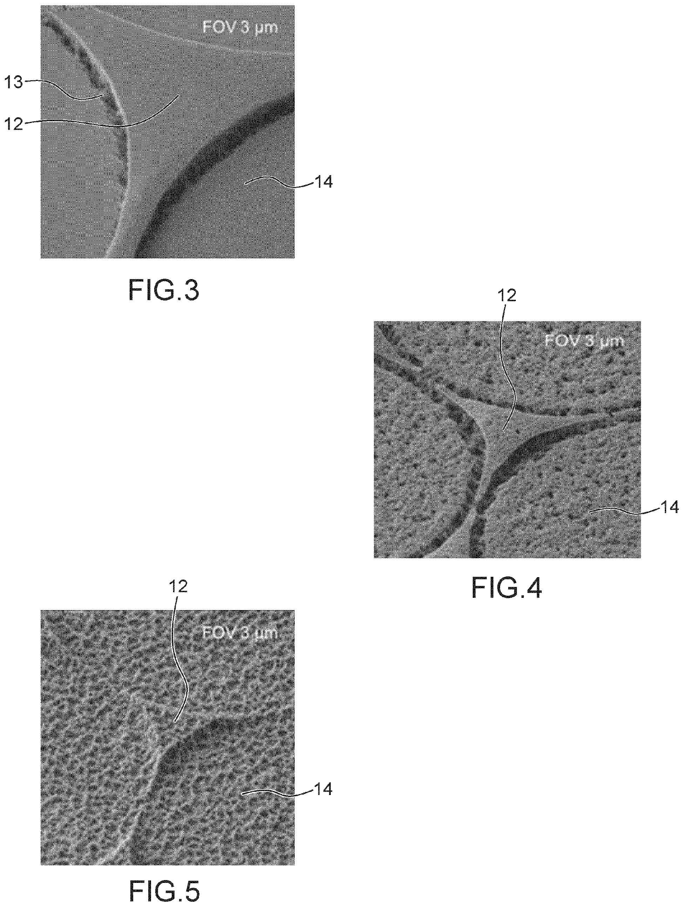

Les figures 3-5 sont des exemples comparatifs, pour une résine commerciale avec une teneur de 4 % en masse molaire (version 4 de l'UVA de chez EVG). Ces 3 figures sont des images SEM (FOV = 3 µm), et correspondent à la mise en oeuvre de divers plasmas, sans bias, à basse température (par exemple comprise entre 50°C et 60°C) et pour une durée de gravure de 200 sec :
- la figure 3 correspond à un plasma O₂, sans espèce fluorée; on voit sur cette figure que le gaz a légèrement consommé la résine au pied des motifs, mais n'a pas modifié la rugosité de la partie haute ni de la partie basse des motifs (donc n'appliquant pas l'enseignment de l'invention) ; les zones aux pieds des motifs sont des zones de contraintes, dans lesquelles les chaînes de polymère peuvent avoir subi une élongation et où le silicium est réparti de manière moins homogène qu'ailleurs, ce qui peut expliquer la gravure dans ces zones ;
- La figure 4 correspond à la mise en oeuvre d'un plasma SF₆/O₂ avec un ratio de 1/25 ; on voit sur cette figure que le gaz a consommé de la résine dans toutes les parties et la rugosité moyenne Ra obtenue en surface est de 15 nm; sur cette figure, comme sur la figure 5, le Si est oxydé en SiO₂, lequel est non consommé;
- La figure 5 correspond à la mise en oeuvre d'un plasma SF₆/O₂ avec un ratio de 3/25 ; on voit sur cette figure que le gaz a attaqué la résine dans toutes les parties et la rugosité moyenne obtenue en surface est de 25 nm ; elle est donc plus importante que dans le cas de la figure 4, pour laquelle la proportion de SF₆ était inférieure.

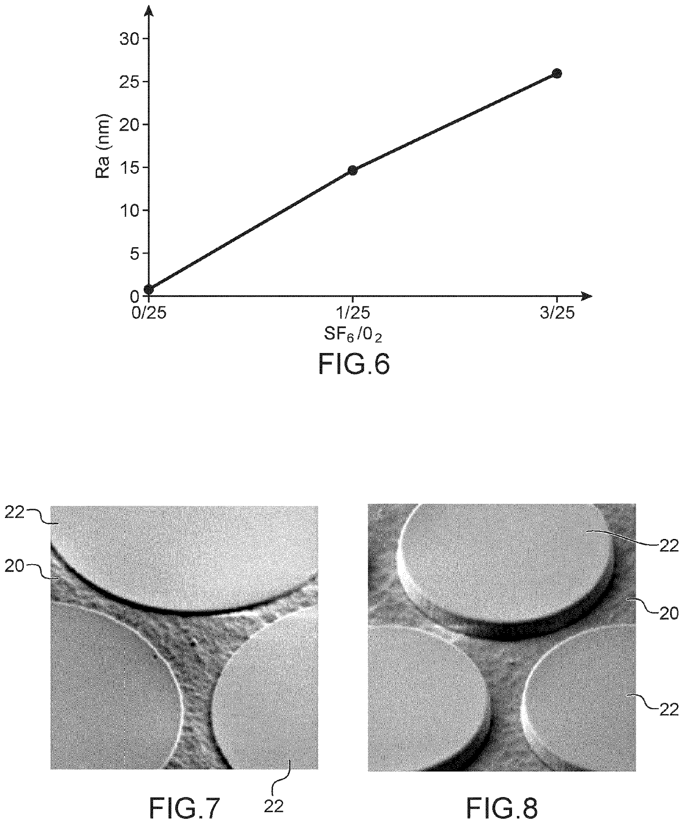

Plus généralement, on a représenté en figure 6 l'évolution de la rugosité moyenne Ra obtenue en surface en fonction du rapport SF₆/O₂ (ce dernier évoluant entre 0:25 et 3:25, avec un point intermédiaire à 1:25) et ceci pour la même résine que celle utilisée pour les exemples des figures 3-5. On voit donc, d'après cette figure, qu'il est possible d'ajuster linéairement la rugosité moyenne obtenue, dans cet exemple entre 0,5 nm et 30 nm. Une évolution similaire est obtenue pour des temps de gravure variables mais avec un ratio SF₆/O₂ fixe.

L'utilisation d'une résine avec une teneur trop importante en Si/SiO₂ ne permet pas d'obtenir la rugosité souhaitée (par exemple le SiArc avec 40 - 50 %, encore désigné par JSR ISX412. Par contre il est possible de réduire cette teneur pour la ramener dans la gamme souhaitée, par exemple en ajoutant un composé organique (résine ou précurseur).

Selon un exemple, on utilise une résine ISX412 et le précurseur IRGACURE 4265 de chez BASF. A 0% d'agent (ou de précurseur) ajouté ce matériau est non imprimable ; il le devient avec une proportion de 5 à 15% d'agent ajouté, pour des durées d'impression comprises entre 20 minutes (à 5% d'IRGACURE) et 5 minutes (à 15% d'IRGACURE), sous une pression de 30 bar et à 100°C.

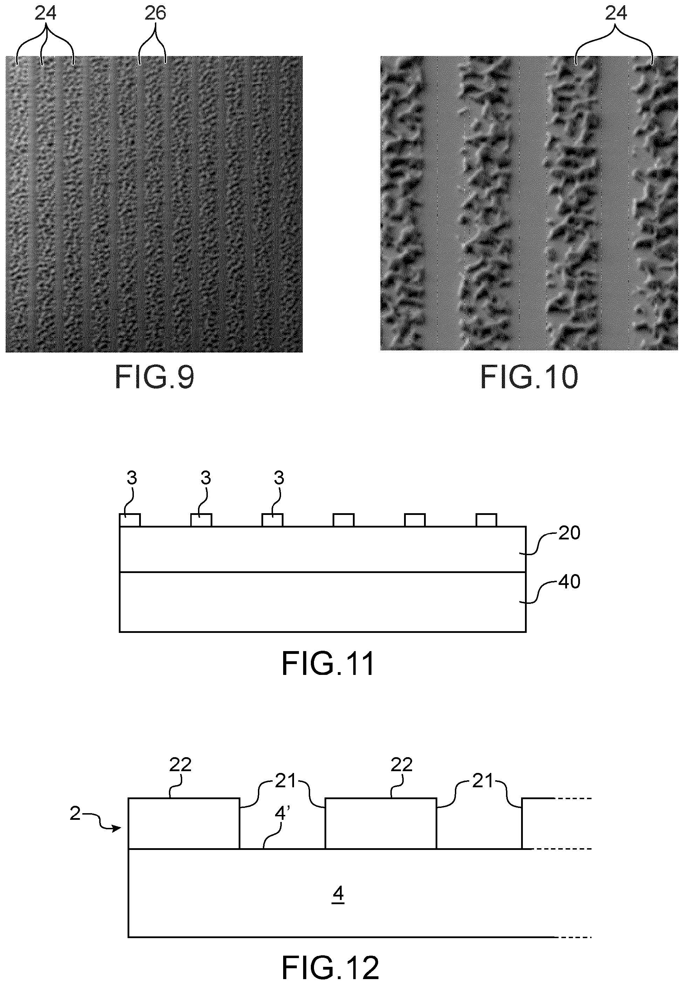

En figures 7-10, on présente des exemples avec 5% d'IRGACURE (figures 7 et 8) et avec 15% d'IRGACURE (figures 9 et 10, sur lesquelles les motifs sont réalisés sous forme de bandes parallèles), dans lesquels la résine est imprimée, puis l'ensemble peut être recouvert d'une résine organique 20 (qui permet de protéger le substrat sous-jacent pour faire un traitement ultérieur uniquement sur la partie haute des motifs).

Une étape de gravure (« etch-back ») est appliquée pour faire réapparaître les parties supérieures 22 des motifs imprimés, comme illustré en figure 7 ; mais la rugosité n'est pas révélée (car proportion de SiO₂ trop élevée, supérieure à 30%), et elle ne l'est pas non plus en prolongeant la gravure (sous plasma O₂/HBr, avec bias de 500 W) comme présenté sur la figure 8.

En utilisant la formulation à 15% d'IRGACURE la rugosité de la partie supérieure des motifs 24 est révélée dès l'étape d'etch-back (figure 9) (car la proportion de Si/SiO2 est dans la gamme 1-30 %), et il est possible de retirer complètement la partie organique 26 simplement en prolongeant la durée de gravure (figure 10; également sous plasma O₂/HBr avec bias de 500 W).

Des figures 7-10 on peut conclure que l'on peut moduler la quantité de Si/SiO2 afin de la ramener sous le seuil des 30 % (en masse molaire) afin de permettre la mise en oeuvre du procédé selon l'invention.

Dans les exemples décrits ci-dessus, la couche de résine 2 est déposée sur un substrat 4 (voir figure 2A) en silicium.

Il est possible, en variante, de déposer la résine sur une couche 40 (voir figure 11) de résine négative, après réticulation ou polymérisation de cette dernière. On peut alors réaliser, comme ci-dessus, des motifs micrométriques par nano-impression dans la couche 2 : cette technique permet de garder de la résine au fond des motifs, comme en figure 2A. En variante, les motifs micrométriques peuvent être réalisés par lithographie optique ou électronique, à l'aide d'un masque 3, comme représenté en figure 11. Dans ce cas, le fond des motifs est formé par la surface supérieure 4' du substrat sous-jacent mais pas par la résine dans laquelle les motifs sont réalisés.

Ainsi, la figure 12 représente des motifs micrométriques réalisés dans une couche 2 de résine, par lithographie optique ou électronique, sur un substrat support 4 en silicium, dont la surface supérieure 4' constitue le fond des motifs.

En fonction du caractère isotrope ou anisotrope du plasma, la rugosité peut être formée seulement sur les parties hautes 22 des motifs (figure 12), ou à la fois sur les parties hautes 22 et les parties latérales 21. De même, dans le cadre de la figure 2B ci-dessus, la rugosité peut être réalisée uniquement sur la partie supérieure 22 et inférieure 23 des motifs micrométriques, ou également sur les parties latérales 21, en utilisant un plasma anisotrope.

Une surface structurée obtenue par un procédé selon l'invention permet de greffer des agents fluorés (lesquels aident au démouillage et donc à l'évacuation des bactéries « mortes » plus facilement dans un solvant comme de l'eau) ou du silane. La greffe a lieu sur les motifs nanométriques.

Quel que soit le mode de réalisation retenu, les motifs peuvent avoir diverses formes, par exemple circulaire, comme illustré sur les figures 1A-1B, 7, 8 ou sous forme de bandes parallèles entre elles, comme illustré en figures 9, 10.

Une propriété d'une surface structurée obtenue par un procédé selon l'invention est que les virus ne peuvent y adhérer du fait des microstructures et du greffage réalisée en surface ; les virus sont en outre endommagés par la rugosité (structure nanométrique) et le cas échéant par la microstructure lorsque celle-ci est de forme saillante.

## Revendications

1. Procédé de réalisation d'une structure hybride, comportant :
- la formation, sur un substrat (4, 40), d'une couche (2) de résine minérale comportant une proportion de Si et/ou SiO₂ comprise entre 1% et 30% en masse molaire ;
- la formation d'une structure comportant une pluralité de motifs (6) dans cette couche, ayant au moins une dimension (h, l), mesurée parallèlement ou perpendiculairement au substrat, comprise entre 50 nm et 500 µm ;
- la formation d'une rugosité (Ra) sur au moins une partie de la surface des motifs, par un procédé oxydant comprenant au moins une espèce ou gaz consommant une partie de la phase minérale.

2. Procédé selon la revendication 1, ledit procédé oxydant mettant en oeuvre un élément fluoré.

3. Procédé selon la revendication 2, ledit procédé oxydant mettant en oeuvre du SF₆ et/ou du CF₄.

4. Procédé selon la revendication 3, ledit procédé oxydant mettant en oeuvre du SF₆, avec un ratio de SF₆/O₂ compris entre 1:25 et 3:25.

5. Procédé selon l'une des revendications 1 à 4, la rugosité des motifs étant obtenue par une gravure plasma, isotrope ou anisotrope.

6. Procédé selon l'une des revendications 1 à 5, le substrat (4, 40) étant en silicium ou en une résine négative réticulée.

7. Procédé selon l'une des revendications 1 à 6, ladite pluralité de motifs dans la couche (2) de résine étant obtenue par nano impression, ou par lithographie optique ou électronique.

8. Procédé selon l'une des revendications 1 à 7, la rugosité moyenne (Ra) obtenue sur au moins une partie des motifs étant comprise entre 0,5 nm et 30 nm.

9. Procédé selon l'une des revendications 1 à 8, des motifs (6) voisins étant séparés par une distance comprise entre 50 nm et 1mm.

10. Procédé selon l'une des revendications 1 à 9, comportant en outre une étape de greffage d'au moins un agent fluoré ou de silane.

## Patentansprüche

1. Verfahren zum Herstellen einer hybriden Struktur, das Folgendes umfasst:
- Bilden einer Schicht (2) aus Mineralharz, die einen Anteil von Si und/oder SiO₂ umfasst, der zwischen 1 % und 30 % der Molmasse liegt, auf einem Substrat (4, 40);
- Bilden einer Struktur, die eine Vielzahl von Mustern (6) in der Schicht umfasst, die mindestens eine parallel oder senkrecht zum Substrat gemessene Abmessung (h, l) aufweist, die zwischen 50 nm und 500 µm liegt;
- Bilden einer Rauheit (Ra) auf mindestens einem Teil der Oberfläche der Muster durch ein Oxidationsverfahren, das mindestens eine Spezies oder ein Gas umfasst, das einen Teil der Mineralphase verbraucht.

2. Verfahren nach Anspruch 1, wobei das Oxidationsverfahren ein fluorhaltiges Element verwendet.

3. Verfahren nach Anspruch 2, wobei das Oxidationsverfahren SF₆ und/oder CF₄ verwendet.

4. Verfahren nach Anspruch 3, wobei das Oxidationsverfahren SF₆ mit einem Verhältnis von SF₆/O₂ zwischen 1:25 und 3:25 verwendet.

5. Verfahren nach einem der Ansprüche 1 bis 4, wobei die Rauheit der Muster durch isotropes oder anisotropes Plasmaätzen erhalten wird.

6. Verfahren nach einem der Ansprüche 1 bis 5, wobei das Substrat (4, 40) aus Silizium oder einem vernetzten Negativharz besteht.

7. Verfahren nach einem der Ansprüche 1 bis 6, wobei die Vielzahl von Mustern in der Harzschicht (2) durch Nanoprägung oder durch optische Lithografie oder Elektronenstrahllithografie erhalten werden.

8. Verfahren nach einem der Ansprüche 1 bis 7, wobei die erhaltene durchschnittliche Rauheit (Ra) auf mindestens einem Teil der Muster zwischen 0,5 nm und 30 nm liegt.

9. Verfahren nach einem der Ansprüche 1 bis 8, wobei benachbarte Muster (6) durch einen Abstand, der zwischen 50 nm und 1 mm liegt, getrennt sind.

10. Verfahren nach einem der Ansprüche 1 bis 9, das ferner einen Schritt des Aufpfropfens von mindestens einem fluorhaltigen Mittel oder Silan umfasst.

## Claims

1. A method for producing a hybrid structure, including:
- forming, on a substrate (4, 40), a layer (2) of mineral resin including a proportion of Si and/or SiO₂ comprised between 1% and 30% by molar mass;
- forming a structure including a plurality of patterns (6) in this layer, having at least one dimension (h, I), measured parallel or perpendicular to the substrate, comprised between 50 nm and 500 pm;
- forming a roughness (Ra) on at least part of the surface of the patterns, by an oxidising method comprising at least one species or gas consuming part of the mineral phase.

2. The method according to claim 1, said oxidising method using a fluorinated element.

3. The method according to claim 2, said oxidising method using SF₆ and/or CF₄.

4. The method according to claim 3, said oxidising method using SF₆, with a SF₆/O₂ ratio comprised between 1:25 and 3:25.

5. The method according to one of claims 1 to 4, the roughness of the patterns being obtained by plasma, isotropic or anisotropic etching.

6. The method according to one of claims 1 to 5, the substrate (4, 40) being made of silicon or a crosslinked negative resin.

7. The method according to one of claims 1 to 6, said plurality of patterns in the resin layer (2) being obtained by nano-printing, or by optical or electronic lithography.

8. The method according to one of claims 1 to 7, the average roughness (Ra) obtained on at least part of the patterns being comprised between 0.5 nm and 30 nm.

9. The method according to one of claims 1 to 8, neighbouring patterns (6) being separated by a distance comprised between 50 nm and 1 mm.

10. The method according to one of claims 1 to 9, further including a step of grafting at least one fluorinated agent or silane.
